Europäisches Patentamt

European Patent Office

Office européen des brevets

(11) Publication number: **0 082 499**

**A2**

(12) **EUROPEAN PATENT APPLICATION**

(21) Application number: **82111733.0**

(22) Date of filing: **17.12.82**

(51) Int. Cl.³: **H 03 H 11/48**

(30) Priority: **22.12.81 US 333400**
**22.12.81 US 333445**

(43) Date of publication of application:
**29.06.83 Bulletin 83/26**

(84) Designated Contracting States:
**DE FR IT NL SE**

(71) Applicant: **Western Electric Company, Incorporated**
**222 Broadway**
**New York New York 10038(US)**

(72) Inventor: **Rolfe, Robert Menuhin**
**611 Springfield Avenue**
**Summit New Jersey 07901(US)**

(72) Inventor: **Shoji, Masakazu**
**4 Highmount Avenue**
**Warren New Jersey 07060(US)**

(74) Representative: **Blumbach Weser Bergen Kramer**
**Zwirner Hoffmann Patentanwälte**
**Radeckestrasse 43**
**D-8000 München 60(DE)**

(54) Single terminal negative capacitance generator.

(57) The combination of an amplifier (A) with a capacitor (CF) connected between an input and output terminal is coupled to a data bus (Bus B) reduce the effective capacitance on the bus and thus to enhance the response time of information sent through the data bus.

FIG. I

EP 0 082 499 A2

# SINGLE TERMINAL NEGATIVE CAPACITANCE GENERATOR

This invention relates to circuits having conduits that have a capacitance associated therewith that may be harmful.

Many of today's electronics systems use MOS circuitry which selectively drives a relatively high capacitance line (bus). One method for reducing response time is to increase the physical size of all the MOS drive devices so as to increase the drive capability by lowering the resistance. This also increases the capacitance on the bus, which undesirably increases response time. A point is reached at which increasing the size of the MOS driver devices proportionally increases the capacitance on the bus such that there is little or no net reduction of response time.

It is desirable in many instances to reduce the response time between various interconnected MOS circuits beyond that which can be achieved by increasing the physical size of the MOS driver devices.

One embodiment of the present invention is directed to the combination of an amplifier, a capacitance means connected between a first input terminal and an output terminal of the amplifier, and conduit means (bus, data bus, conductor) which is coupled to the first input terminal of the amplifier. The bus couples a transmitter at one end to a receiver at the other end or couples two transceivers. The response time of signals passing between the transmitter and receiver through the bus is proportional to the total load capacitance associated with the transmitter, the receiver, and the bus. Proper selection of the characteristics of the amplifier, the value of the capacitance means, and the ratio of the capacitance means to the total load capacitance, facilitates a reduction in the total capacitance between transmitter and receiver. This provides an enhancement of the response time.

In the drawing:

FIG. 1 illustrates a first embodiment of the invention; and

FIG. 2 illustrates another embodiment of the invention.

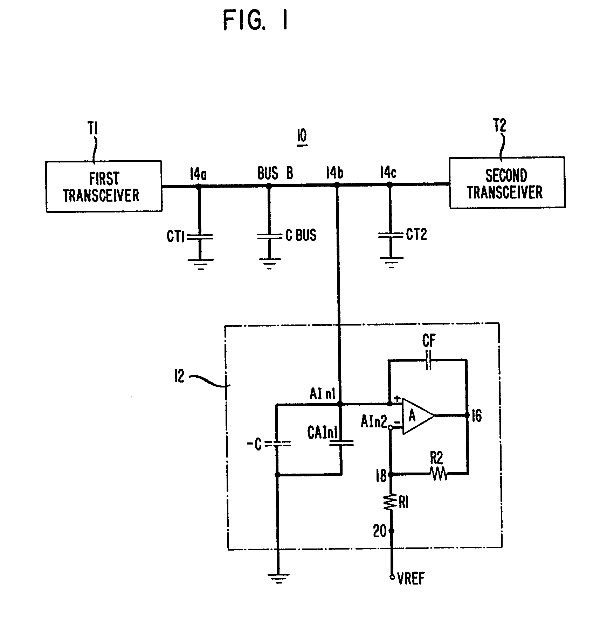

Referring now to Fig. 1 there is illustrated a system 10 comprising a first transceiver T1, a second transceiver T2, and a negative capacitance generator which is illustrated within dashed line rectangle 12 and may be denoted as negative capacitance generator 12. A capacitance CT1 is associated with an input/output terminal 14a of T1 and a capacitance CT2 is associated with an input/output terminal 14c of T2. Terminals 14a and 14c are electrically coupled together by conduit means (bus, data bus, conductor) Bus B. Bus B has a capacitance CBus associated therewith which is illustrated as a single capacitor. CBus is actually distributed along the entire length of B. Generator 12, which is coupled to a terminal 14b of Bus B, acts to enhance the response time of information sent between T1 and T2 through Bus B by effectively reducing the total capacitance between T1 and T2.

Negative capacitance generator 12 comprises an amplifier A, a first capacitance means which is illustrated as capacitor CF, a second capacitor CAIn1, which is the input capacitance of A, and first and second resistors R1 and R2. CF has a first terminal connected to a first plus input terminal AIn1 of A, to a terminal 14b along Bus B, and to a first terminal of capacitor CAIn1. AIn1 also serves as the generator 12 output terminal. A second terminal of CF is connected to an output terminal 16 of A. R1 is connected by a first terminal to a terminal 20 and to a reference potential VRef and by a second terminal to a first terminal as R2, to a second input minus terminal AIn2 of A, and to a terminal 18. A second terminal of R2 is connected to terminal 16. The ratio of R2 to R1 plays a

role in determining the gain of A. In some cases R1 and R2 are not needed as many amplifiers have fixed gains. CAIn1 is the parasitic input capacitance associated with input terminal AIn1 of A.

When generator 12 is operating the equivalent capacitance at output terminal AIn1 of generator 12 is the -C capacitor illustrated coupled between terminal AIn1 and ground potential. Generator 12 may be considered a single terminal negative capacitance generator since the AIn1 terminal serves as both an input and output terminal and is the only terminal coupled to Bus B.

The equivalent capacitance between T1 and T2, without negative capacitance generator 12 being disconnected from 14b, is the simple sum of the capacitances of CT1, CT2 and CBus. Assuming that T1 is acting as a transmitter and T2 is acting as a receiver, the equivalent resistance between T1 and T2 is the sum of the output resistance of T1, the resistance of Bus B, and the input resistance of T2. Assuming that T1 is acting as a receiver and T2 is acting as a transmitter, the equivalent resistance between T1 and T2 is the sum of the output resistance of T2, the resistance of Bus B and the input resistance of T1. These resistances, which are denoted as REq, are not illustrated in the drawing. The RC time constant which plays a significant role in determining the response time of information sent between T1 and T2 is thus (REq) (CT1 + CBus + CT2).

Negative capacitance generator 12, with a properly selected response time, with proper capacitance values selected for CF and CAIn1, and with proper ohmic values selected for R1 and R2, causes the effective capacitance appearing at terminal AIn1 to have a negative value such that same actually reduces the total capacitance appearing at 14b to a value which is less than the sum of CT1 + CBUS + CT2. Thus the equivalent capacitance between terminals 14a and 14c is reduced to a value which is less than the sum of CT1 + CBus + CT2. This enhances the response time of information transmitted between T1 and T2 through Bus B by lowering the RC time constant to (REq)(CT1 + CBus + CT2 ꓱC).

An embodiment of system 10 was built and tested. REq was 1000 ohms, the total capacitance of CT1 + CBus + CT2 was 91pF, the capacitance of CF was 70 pF, and VRef = 0 volts. Amplifier A was MSK 880 operational amplifier whose gain was set to 2 by selecting R1 = R2 = 196 ohms. A 3pF capacitor (not illustrated) was connected between terminals 16 and 18 to help stabilize the MSK 880 amplifier. The response time of the MSK 880, using the above denoted values of resistances of R1 and R2, is typically 5 nanoseconds. The rise time propagation delay (the time delay from the time the input signal is at 50% of the transition between a first logic level and the opposite logic level until the output reaches the corresponding 50% point) without generator 12 connected to 14b of Bus B was 100 nanoseconds. The measured rise time propagation delay was 45 nanoseconds with generator 12 connected to Bus B.

In many useful cases the response time of the amplifier is selected such that it is approximately two times or greater less than the enhanced response time expected. The gain of the amplifier in many useful cases is two or greater.

The response time of information sent between T1 and T2 through Bus B is proportional to the gain and response time of amplifier A. Generally as the gain of A increases the response time of A decreases (is enhanced) and the response time of information sent between T1 and T2 is enhanced (decreases). Generally as the ratio of CF to the total uncompensated capacitance loading terminal 14b of Bus B decreases the response time of information sent between T1 and T2 is enhanced (decreases). A typical range for this capacitance ratio is 0.001 to 100.

Generator 12 is designed such that negative capacitance generated at the AIn1 terminal is not sufficient to cause sustained oscillations between T1 and

T2.

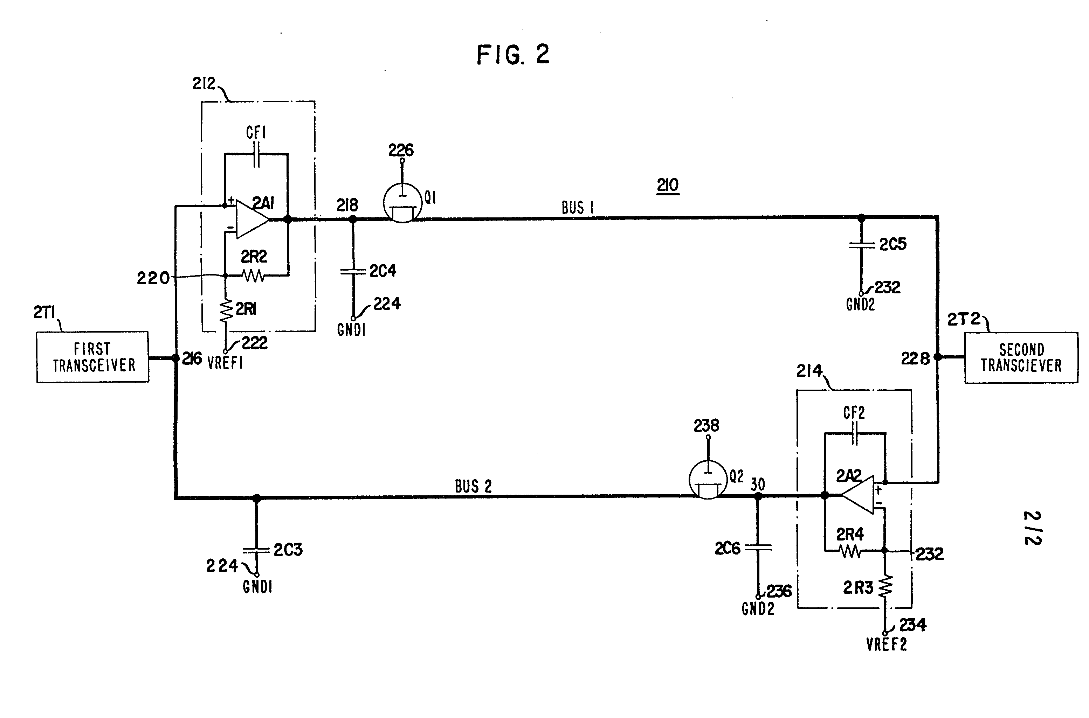

Referring now to Fig. 2, there is illustrated a system 210 comprising a first transceiver 2T1, a second transceiver 2T2, a first amplifier-capacitor combination illustrated within dashed line rectangle 212 and to be denoted as circuitry 212, a second amplifier-capacitor combination illustrated within dashed line rectangle 214 and to be denoted as circuitry 214, switching device Q1 having a control terminal 226 and first and second output terminals, a second switching device 2Q2 having a control terminal 238 and first and second output terminals, capacitors 2C3, 2C4, 2C5, 2C6 and 2C7 and electrical conduits Bus 1 and Bus 2. 2C3, 2C4, 2C5, 2C6 and 2C7 represent the total capacitive loading of all components and/or a Bus on the terminal to which same is illustrated coupled.

System 210 is bidirectional in that analog or digital information may be transmitted from 2T1 to 2T2 or from 2T2 to 2T1. Circuitry 212 and circuitry 214 provide amplification and/or level shifting and cause the capacitive loading between 2T1 and 2T2 to be reduced from what would exist if circuitry 212 and circuitry 214 were not used. Thus the response time of signals transmitted between 2T1 and 2T2 is enhanced.

Circuitry 212 comprises a capacitance means which is illustrated as capacitor CF1, resistors 2R1 and 2R2, and an amplifier 2A1 having a first plus input terminal, a second minus input terminal, and an output terminal. The first plus input terminal of 2A1 is coupled to a first terminal of CF1, to an input/output terminal of 2T1, to a first terminal of 2C3, to a second output terminal of 2Q2 (which is illustrated as an MOS transistor) through Bus 2, and to first system terminal 216. The output terminal of 2A1 is coupled to a second terminal of CF1, a first output terminal of Q1 (which is illustrated as an MOS transistor), to a first terminal of 2R2, to a first terminal of 2C4, and to a second system terminal 218. 2R1 is illustrated coupled by a first terminal to a second terminal of 2R2, to the second minus input terminal of 2A1 and to a terminal 220. A second terminal of 2R1 is coupled to a potential source VRef1 and to a terminal 222. 2R1 and 2R2 are used to set the gain of 2A1 and are not always needed as some amplifiers may have preselected gains. The parasitic capacitance of the first plus input terminal of 2A1 is not explicitly illustrated and labeled but is included as part of 2C3. Second terminals of 2C3 and 2C4 are couplped to a ground terminal Gnd 1 and to a terminal 224.

Circuitry 214 comprises a capacitance means illustrated as a capacitor CF2, resistors 2R3 and 2R4, and an amplifier 2A2 having a first plus input terminal, a second minus input terminal, and an output terminal. The first plus input terminal of 2A2 is coupled to a first terminal of 2CF2, to an input/output terminal of 2T2, to a first terminal of 2C5, to a second output terminal of Q1 through an electrical Bus 1, and to a third system terminal 228. The output terminal of 2A2 is coupled to a first terminal of 2C6, to a first output terminal of 2Q2, to a first terminal of 2R4, and to a fourth system terminal 230. A second terminal of 2R4 is coupled to the second minus input terminal of 2A2, to a first terminal of 2R3, and to a terminal 232. A second terminal of 2R3 is coupled to a potential source VRef2 and to a terminal 234. Second terminals of 2C5 and 2C6 are coupled to a ground terminal Gnd 2 and to a terminal 236. 2R3 and 2R4 are used to set the gain of 2A2 and are not always needed as some amplifiers have preselected gains. The parasitic capacitance of 2A2 is not explicitly illustrated and labeled but is included as part of 2C5. The control (gate) terminals of 2T1 and 2T2 are typically coupled to control circuitry (not illustrated) which provides signals that allow essentially only one of 2T1 or 2T2 to conduct information (signals) between the output terminals thereof while the other is held non-conductive. A variety of well known control circuits can be used to obtain this function.

System 210 operates as follows: Assuming it is desired to send information from 2T1 to 2T2, Q1 is biased on by a control signal applied to gate terminal 226 and Q2 is biased off by a control signal applied to gate terminal 238. A signal from 2T1 propagates through 2A1, Q1, Bus 1, and is received at 2T2 and at the first plus input terminal of 2A2. Circuitry 212 acts to amplify (and/or level shift) the information (signal) transmitted from 2T1, and the signal reaches the first plus input terminal of 2A1. Circuitry 212 further causes the load capacitance 2C3 to be reduced from the value that would result if 2CF1 were not used. Circuitry 214 acts as a single terminal negative capacitance generator which causes the effective value of 2C5 to be lower than would be the case if circuitry 214 were not coupled to terminal 228. Thus, circuitry 214 acts as in Fig. 1. No information propagates past output terminal 230 of 2A2 since Q2 is biased off.

If it is later desired to transmit (send) information from 2T2 to 2T1, then Q1 is biased off and 2Q2 is biased on. Circuitry 214 now acts to amplify and/or level shift the signal applied to the first plus input of 2A2. It is further acts to cause the load capacitance 2C5 to be reduced from the value that would result if just 2A2 were used but if 2CF2 were not used. Circuitry 212 acts as a single terminal negative capacitance generator which causes the effective value of 2C3 to be lower than would be the case if circuitry 212 were not coupled to terminal 216, as in Fig. 1. No information propagates past output terminal 218 of 2A1 since Q1 is biased off.

With Q1 biased on and Q2 biased off, information can be transmitted from 2T1 through 2A1, Q1 and Bus 1 and be received by 2T2 with the Capacitance on terminal 216 being reduced by circuitry 212, the information being amplified and/or level shifted by 2A1, and the capacitance on terminal 228 being reduced by circuitry 214. With Q2 biased on and Q1 biased off, information can be transmitted from 2T2 through 2A2, Q2 and Bus 2 and be received by 2T2 with the capacitance on terminal 228 being reduced by circuitry 214, the information being amplified and/or level shifted by 2A2, and the capacitance on terminal 216 being reduced by circuitry 212. The reduction in the capacitive loading on terminals 216 and 228 serves to enhance the response time of information transferred between 2T1 and 2T2.

In many useful cases the response time of amplifiers 2A1 and 2A2 should be at least approximately two times less than that of the enhanced response time expected, and the gain of 2A1 and 2A2 should be approximately two or greater. The response time of information received at 2T1 is proportional to the ratio of 2CF1 to 2C3 and the response time of information received at 2T2 is proportional to the ratio of 2CF2 to 2C5. As these ratios of capacitance decrease the corresponding response times are enhanced (decreased).

The embodiments described herein are intended to be illustrative of the general principles of the invention. Various modifications are possible consistent with the spirit of the invention. For example, sitching devices Q1 and Q2 could be bipolar transistors, JFETS, gated diode switches, or a variety of other types of switches. Amplifier 1 and 2 could have different gains and response times and need not be identical. 2CF1 and 2CF2 may also have different values as may 2C3, 2C4, 2C5, and 2C6. Still further, 2T1 could be just a transmitter or just a receiver and correspondingly 2T2 could be just a receiver or a transmitter. Still further, additional transceivers, and/or receivers, and/or transmitters could be coupled to terminals 216 and 228. Still further, separate voltage dividers can be inserted between the output terminal 2A1 of circuitry 212 and the first output terminal of 2Q1 and between the output terminal of 2A2 of circuitry 214 and the first output terminal of Q2 in order to attenuate information (signals) and/or to match the impedance of the bus being driven. Similar modifications and alternatives are applicable to Fig. 1.

Claims

1. A circuit comprising: a conduit means (e.g. BUS B, BUS1) having a capacitance (e.g. C BUS) associated therewith,

CHARACTERIZED BY

an amplifier (e.g. A, 2A2) having a first input terminal (e.g. AIn1) and an output terminal (e.g. 16); capacitance means (e.g. CF) having first and second terminals coupled to the first input terminal and the output terminal of the amplifier, respectively; the first input terminal of the amplifier being coupled to the conduit means; and the gain of the amplifier and the value of the capacitance means being selected such that total load capacitance on the conduit means is less than would be the case if the amplifier and capacitive means were not coupled to the conduit means.

2. The circuit of claim 1

FURTHER CHARACTERIZED IN THAT

the conduit means (e.g. BUSB) is adapted to be coupled by a first terminal (e.g. 14a) to a first receier or transmitter (e.g. T1) which has a capacitance (e.g. CT1) associated therewith and further being adapted to be coupled by a second terminal (e.g. 14c) to a second receiver or transmitter which has a capacitance (e.g. CT2) associated therewith.

3. The combination of claim 2

FURTHER CHARACTERIZED IN THAT

the gain of the amplifier is approximately two or greater and the amplifier has a response time which is at least approximately two times less than a desired response time of information transmitted through the conductor.

4. The circuit of claim 1 further character by:

a second conduit means (e.g. BUS2) having a capacitance (e.g. 2C3) associated therewith;

a second amplifier (e.g. 2A1) having a first input terminal (e.g. 216) coupled to the second conduit means and an output terminal (e.g. 218);

second capacitance means (e.g. CF1) having first and second terminals connected to the first input terminal and the output terminal of the second amplifier, respectively;

the gain of the second amplifier and the value of the second capacitance means being selected such that the total load capacitance on the second conduit means is less than would be the case if the second amplifier and second capacitance means were not coupled to the second conduit means.

the output terminal (e.g. 30) of the amplifier (e.g. 2A2) being coupled to the second conduit means (e.g. BUS2) and the output terminal of the second amplifier being coupled to the conduit means (e.g. BUS1).

5. The circuit of claim 4

FURTHER CHARACTERIZED IN THAT

the output terminal of the second amplifier (e.g. 2A1) is coupled to the first conduit means (e.g. BUS1) via a first switching device (e.g. Q1) and the output terminal of the amplifier (e.g. 2A2) is coupled to second conduit means (e.g. BUS2) via a second switching device (e.g. Q2); and

control terminals (e.g. 238, 226) of the switching devices are connected so as to allow essentially only one switching device to be conductive at a given time.

6. The circuit of claim 5

FURTHER CHARACTERIZED IN THAT

the second conduit means (e.g. BUS2) and the first input terminal of the second amplifier (e.g. 2A1) are connected to a first transmitter, receiver or tranceiver (e.g. 2T1);

the conduit means (e.g. BUS1) and the first input terminal of the amplifier (e.g. 2A2) are connected to a second transmitter, receiver or tranceiver (e.g. 2T2).

7. The circuit of claim 6

FURTHER CHARACTERIZED IN THAT

the gain of the amplifier and the second amplifier is each two or greater, and the response time of the amplifier (e.g. 2A2) is at least approximately two times less than that of a desired response time of information transmitted through the conduit means (e.g. BUS1) and the response time of the second amplifier (e.g. 2A1) is at least approximately two times less than that of a desired response time of information transmitted through the second conduit means (e.g. BUS2).

FIG. 1

FIG. 2